(19) Europäisches Patentamt / European Patent Office / Office européen des brevets

(11) **EP 4 266 850 A1**

(12) **EUROPEAN PATENT APPLICATION**
published in accordance with Art. 153(4) EPC

(43) Date of publication:
**25.10.2023 Bulletin 2023/43**

(21) Application number: **21906659.4**

(22) Date of filing: **15.12.2021**

(51) International Patent Classification (IPC):
*H05K 9/00* (2006.01)   *B32B 27/00* (2006.01)
*H01G 4/00* (2006.01)   *H01G 4/06* (2006.01)
*H01G 4/20* (2006.01)   *H01G 4/33* (2006.01)

(52) Cooperative Patent Classification (CPC):
**B32B 27/00; H01G 4/00; H01G 4/06; H01G 4/20; H01G 4/33; H05K 9/00**

(86) International application number:
**PCT/JP2021/046304**

(87) International publication number:
**WO 2022/131298 (23.06.2022 Gazette 2022/25)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **17.12.2020 JP 2020209095**

(71) Applicant: **TOPPAN INC.**
**Tokyo 110-0016 (JP)**

(72) Inventors:
• **NISHIYAMA Hiroyoshi**
**Tokyo 110-0016 (JP)**
• **SHODA Ryo**
**Tokyo 110-0016 (JP)**

(74) Representative: **TBK**
**Bavariaring 4-6**
**80336 München (DE)**

(54) **METHOD FOR MANUFACTURING DIELECTRIC LAYER, RESIN COMPOSITION, AND LAMINATE INCLUDING DIELECTRIC LAYER**

(57)   A manufacturing method according to the present disclosure is for manufacturing a dielectric layer included in a reflective electromagnetic wave absorber, the method including the steps of: preparing a resin composition containing at least one dielectric compound and a resin component, and having a relative permittivity higher than 10.0 at a frequency of 3.7 GHz or 90 GHz; and forming a dielectric layer made from this resin composition and having a thickness of 20 to 7000 $\mu$m. A resin composition according to the present disclosure is used to form a dielectric layer included in a reflective electromagnetic wave absorber, the resin composition containing at least one dielectric compound and a resin component, and having a relative permittivity higher than 10.0 at a frequency of 3.7 GHz or 90 GHz.

FIG.1

EP 4 266 850 A1

## Description

[Technical Field]

The present disclosure relates to a method for manufacturing a dielectric layer included in a reflective electromagnetic wave absorber, a resin composition used to form a dielectric layer, and a laminate including a dielectric layer.

[Background Art]

In preparation for a rapid increasing amount of information, higher speed of mobile objects, autonomous driving, and practical use of IoT (Internet of Things), the demand for communication, radars, security scanners, and the like capable of dealing with each of the circumstances is more and more increasing recently. Along with this demand, a technique is rapidly advancing that pertains to next-generation electromagnetic-wave high-speed wireless communication systems using 5G, millimeter waves, or terahertz waves.

Products using electromagnetic waves sometimes interfere with electromagnetic waves generated from another electronic device and cause a malfunction. As means for preventing this malfunction, reflective electromagnetic wave absorbers referred to as a λ/4 type are known. PTL 1 discloses a radio wave absorber including a dielectric layer between a resistance film including ultrafine conductive fibers and a radio wave reflector. PTL 2 discloses an electromagnetic wave absorber including a first layer that is a dielectric layer or a magnetic layer, and a conductive layer disposed on at least one side of this first layer, the first layer having a relative permittivity of 1 to 10.

[Citation List]

[Patent Literatures]

[PTL 1] JP 2005-311330 A
[PTL 2] WO2018/230026 A

[Summary of the Invention]

[Technical Problem]

The dielectric layer included in a reflective electromagnetic wave absorber is a layer for interfering with incident electromagnetic waves using reflected electromagnetic waves. The thickness of the dielectric layer is set on the basis of the following equation.

$$d = \lambda/(4(\varepsilon_r)^{1/2})$$

In the equation, $\lambda$ represents the wavelength (unit: m) of electromagnetic waves to be reduced, $\varepsilon_r$ represents the relative permittivity of a material forming the dielectric layer, and d represents the thickness (unit: m) of the dielectric layer. The phase of the incident electromagnetic waves and the phase of the reflected electromagnetic waves are shifted from each other by $\pi$, and a reflection attenuation is thereby obtained. Conventionally, increasing the thickness of the dielectric layer has been only a way to achieve a sufficient reflection attenuation. Therefore, there has still been room for improving production efficiency of the dielectric layer and saving of space.

The present disclosure provides a method for efficiently manufacturing a dielectric layer that is included in a reflective electromagnetic wave absorber and can realize an excellent reflection attenuation. In addition, the present disclosure provides a resin composition used to form the dielectric layer, and a laminate including the dielectric layer.

[Solution to Problem]

One aspect of the present disclosure relates to a method for manufacturing a dielectric layer included in a reflective electromagnetic wave absorber. This manufacturing method includes the steps of: preparing a resin composition containing at least one dielectric compound and a resin component, and having a relative permittivity higher than 10.0 at a frequency of 3.7 GHz or 90 GHz; and forming a dielectric layer made from this resin composition and having a thickness of 20 to 7000 $\mu$m.

In the invention described in PTL 2, the relative permittivity of the first layer is set to the range of 1 to 10 so that excellent electromagnetic wave absorption performance can be exhibited with a bandwidth of 2 GHz or more in a band of 50 to 100 GHz (see paragraph [0016] of PTL 2). In contrast, in the present disclosure, the relative permittivity of the dielectric layer is set to a value higher than 10.0. This is based on the following technical idea. That is, presuming, for example, an actually used 76 GHz in-vehicle millimeter wave radar, the allowable value of occupied frequency bandwidth is limited to the range of 500 MHz (Japan) to 1 GHz (other countries). Absorption performance is sometimes enough when it is sufficiently (for example, -20 dB) exhibited in this approximately 1 GHz frequency band. That is, when the absorption frequency band need not be widened, it is more useful to increase the relative permittivity of the dielectric layer and decrease the thickness of the dielectric layer, and thereby to give priority to production efficiency of the dielectric layer and space saving. Generally, the relative permittivity of the dielectric layer tends to be lower as the frequency is higher. When having a relative permittivity higher than 10.0 at a frequency of 3.7 GHz or 90 GHz, the dielectric layer of the present disclosure can exhibit, as an electromagnetic wave absorber for 5G (28 GHz) and millimeter wave radars (76 GHz), a sufficient effect to solve the problem described above.

One aspect of the present disclosure relates to a resin composition used to form a dielectric layer included in a reflective electromagnetic wave absorber. This resin composition contains at least one dielectric compound and a resin component, and has a relative permittivity higher than 10.0 at a frequency of 3.7 GHz or 90 GHz. The form of the dielectric compound is, for example, a powder, and the dielectric compound preferably has a relative permittivity higher than the relative permittivity of the resin component. Specific examples of the dielectric compound include metal compounds such as titanium oxide and barium titanate. The resin component preferably has a relative permittivity of, for example, 2.5 to 9.5 at a frequency of 3.7 GHz or 90 GHz.

The resin composition itself preferably has adhesiveness. Forming a dielectric layer from the resin composition having adhesiveness enables the dielectric layer to be efficiently attached to a target member. The resin composition preferably has an adhesive strength of 1.0 N/25 mm or more with respect to a stainless 304 steel sheet.

One aspect of the present disclosure relates to a laminate including a dielectric layer. This laminate includes a dielectric layer made from the resin composition and an adhesive layer disposed on at least one surface of the dielectric layer. The laminate having such a structure enables the dielectric layer to be efficiently attached to a target member, with the adhesive layer interposed between the dielectric layer and the target member.

[Advantageous Effects of the Invention]

According to the present disclosure, a method is provided for efficiently manufacturing a dielectric layer that is included in a reflective electromagnetic wave absorber and can realize an excellent reflection attenuation. In addition, according to the present disclosure, provided are a resin composition used to form the dielectric layer, and a laminate including the dielectric layer.

[Brief Description of the Drawings]

Fig. 1 is a sectional view schematically illustrating a first embodiment of a laminate according to the present disclosure.
Fig. 2 is a sectional view schematically illustrating a second embodiment of the laminate according to the present disclosure.

[Description of the Embodiments]

Hereinafter, a plurality of embodiments of the present disclosure are described in detail with reference to drawings. In the drawings, identical symbols are assigned to identical or corresponding parts, and repetitive description is omitted. Positional relationships such as vertical and horizontal directions are based on the positional relationship illustrated in the drawings unless otherwise specified. Further, the dimensional ratio in the drawings is not limited to the ratio illustrated in the drawings.

<First embodiment>

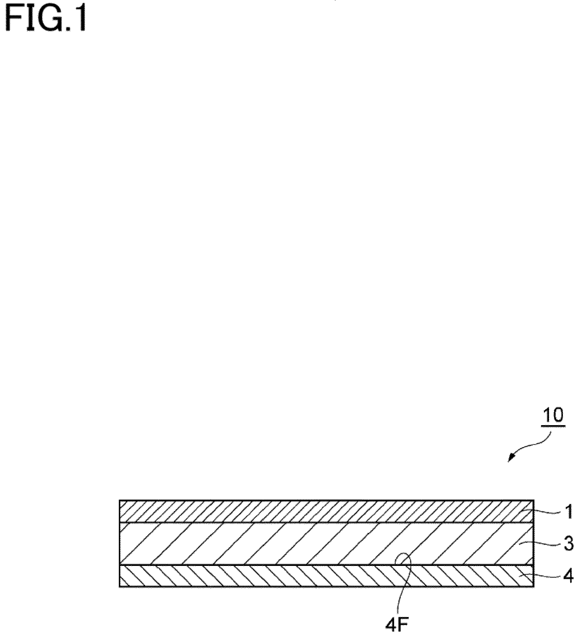

Fig. 1 is a sectional view schematically illustrating a reflective electromagnetic wave absorber according to a first embodiment. An electromagnetic wave absorber 10 illustrated in this drawing has a film shape or a sheet shape, and has a laminate structure including an electromagnetic wave transmission layer 1, a dielectric layer 3, and a reflective layer 4 in this order. The electromagnetic wave absorber having a film shape has a whole thickness of, for example, 24

to 250 μm. On the other hand, the electromagnetic wave absorber having a sheet shape has a total thickness of, for example, 0.25 to 7.1 mm.

(Electromagnetic wave transmission layer)

The electromagnetic wave transmission layer 1 is a layer for allowing electromagnetic waves incident from the exterior to reach the dielectric layer 3. That is, the electromagnetic wave transmission layer 1 is a layer for performing impedance matching according to the use environment or the layer structure of the electromagnetic wave absorber 10. Due to the electromagnetic wave transmission layer 1, the electromagnetic wave absorber 10 having a large reflection attenuation can be obtained. When the electromagnetic wave absorber 10 is used in air (impedance: 377 Ω/□), the sheet resistance of the electromagnetic wave transmission layer 1 may be set according to the relative permittivity of the dielectric layer 3. For example, when the dielectric layer 3 has a relative permittivity of more than 10 at 3.7 GHz, the sheet resistance of the electromagnetic wave transmission layer 1 may be set in the range of 200 to 800 Ω/□ or in the range of 350 to 400 Ω/□. When the dielectric layer 3 has a relative permittivity of more than 10 at 90 GHz, the sheet resistance of the electromagnetic wave transmission layer 1 may be set in the range of 200 to 800 Ω/□ or in the range of 350 to 400 Ω/□.

The electromagnetic wave transmission layer 1 contains an inorganic material or an organic material having conductivity. Examples of the inorganic material having conductivity include nanoparticles or/and nanowires containing one or more selected from the group consisting of indium tin oxide (ITO), indium zinc oxide (IZO), aluminum zinc oxide (AZO), carbon nanotubes, graphene, Ag, Al, Au, Pt, Pd, Cu, Co, Cr, In, Ag-Cu, Cu-Au, and Ni nanoparticles. Examples of an organic material having conductivity include polythiophene derivatives, polyacetylene derivatives, polyaniline derivatives, and polypyrrole derivatives. Particularly from the viewpoints of softness, film formability, stability, and sheet resistance of 377 Ω/□, a conductive polymer containing polyethylenedioxythiophene (PEDOT) is preferable. The electromagnetic wave transmission layer 1 may contain a mixture (PEDOT/PSS) of polyethylenedioxythiophene (PEDOT) and polystyrene sulfonic acid (PSS).

The sheet resistance value of the electromagnetic wave transmission layer 1 is obtained according to the equation: sheet resistance value of conductive material $\sigma = \rho/t$, with the resistivity of the conductive material defined as $\rho$ (Q-m) and the thickness of the conductive material as t (m). Accordingly, the sheet resistance value of the electromagnetic wave transmission layer 1 can be set as appropriate according to the selection of inorganic material or organic material having conductivity or the adjustment of the film thickness of the material. When the electromagnetic wave transmission layer 1 is formed of an inorganic material, the thickness (film thickness) of the electromagnetic wave transmission layer 1 is preferably set to be in the range of 0.1 nm to 100 nm, more preferably in the range of 1 nm to 50 nm. The electromagnetic wave transmission layer 1 having a film thickness of 0.1 nm or more is easily formed uniformly, and tends to be able to more sufficiently exhibit a function as the electromagnetic wave transmission layer 1. On the other hand, an electromagnetic wave transmission layer 1 having a film thickness of 100 nm or less can retain sufficient flexibility and more securely prevent the occurrence of cracking of the thin film caused by external factors such as bending and tension after film formation, and tends to suppress thermal damage to a substrate and shrinkage. When the electromagnetic wave transmission layer 1 is formed of an organic material, the thickness (film thickness) of the electromagnetic wave transmission layer 1 is preferably set to be in the range of 0.1 to 2.0 μm, and is more preferably in the range of 0.1 to 0.4 μm. An electromagnetic wave transmission layer 1 having a film thickness of 0.1 μm or more is easily formed uniformly, and tends to be able to more sufficiently function as the electromagnetic wave transmission layer 1. On the other hand, an electromagnetic wave transmission layer 1 having a film thickness of 2.0 μm or less can retain sufficient flexibility, and tends to be able to more reliably prevent the occurrence of cracking in the thin film caused by external factors such as bending and tension after film formation.

Examples of a film forming method include a dry coating method and a wet coating method.

Examples of the dry coating method include a vacuum vapor deposition method mainly using resistance heating, induction heating, or ion beams (EB), and a sputtering method. In the method using resistance heating, induction heating, or ion beams (EB), and a sputtering method. In the method using resistance heating, a material is put in a ceramic crucible and a current is caused to flow by applying a voltage to a heater around the crucible to heat the crucible in a vacuum, thereby evaporating the inorganic material from an opening and adhering it to a substrate to form a film. The film thickness is controlled by adjusting the film formation rate through control of the distance between the material and the substrate, and the voltage and the current applied to the heater, and by controlling the film formation time using, for example, the opening time of a shutter in batch film forming and the line rate in roll film forming. In the method using ion beams, a current is passed through a filament in a vacuum to discharge electrons and the discharged electrons are directed onto a material through an electromagnetic lens, thereby heating and evaporating the inorganic material and adhering it to a substrate to form a film. This method is used when an inorganic material requiring a large amount of heat for evaporation or a high film formation rate is required. The film thickness is controlled by adjusting the film formation rate through control of the distance between the material and the substrate, the quantity of electrons generated from the filament by the current, the irradiation position of the material through the electromagnetic lens, and the range (aperture) of the electromagnetic lens, and by controlling the film formation time using the opening time of a shutter and the line rate similarly as described above. In the sputtering method, a noble gas, mainly, for example, Ar is introduced onto a target made from an inorganic material, a voltage is applied to cause the Ar to enter a plasma state, and the Ar in a plasma state is accelerated by a voltage and caused to collide with the target, thereby physically ejecting (sputtering) the material and adhering it to a substrate to form a film. Even an inorganic material that cannot be formed into a film by the vacuum vapor deposition method can sometimes be formed into a film by the sputtering method. The film thickness is controlled by adjusting the film formation rate through control of the distance between the target and the substrate, the power applied to the target, and the Ar gas pressure, and by controlling the film formation time using the opening time of a shutter and the line rate similarly as described above. The sputtering method is used mainly when an inorganic material is formed into a film.

The wet coating method is mainly a method for applying a material to a substrate. In the method, a solid material under normal temperature and pressure is dissolved or dispersed in an appropriate solvent to form an ink and applied, and the solvent is then removed by drying to form a film. Examples of an application method include die coating, micro-gravure coating, rod gravure coating, and gravure coating. The film thickness is controlled by applying the ink to the substrate and drying the ink while controlling commonly the solid content of the ink, controlling, in the cases of die coating, the gap of an opening of a die head, and the gap between the substrate and a coater head, and controlling, in the cases of micro-gravure coating, rod gravure coating, and gravure coating, the number and the depth of lines on a cylinder and the cylinder rotation ratio. The wet coating method is used mainly when organic materials or some inorganic dispersion materials are formed into a film.

The sheet resistance value of the electromagnetic wave transmission layer 1 can be measured using, for example, a Loresta GP MCP-T610 (trade name, manufactured by Mitsubishi Chemical Analytech Co., Ltd.).

(Dielectric layer)

The dielectric layer 3 is a layer for causing interference between incident electromagnetic waves and reflected electromagnetic waves. The thickness and the like of the dielectric layer 3 are set so as to satisfy the conditions represented by the following equation.

$$d = \lambda/(4(\varepsilon_r)^{1/2})$$

In the equation, $\lambda$ represents the wavelength (unit: m) of electromagnetic waves to be reduced, $\varepsilon_r$ represents the relative permittivity of a material forming the dielectric layer 3, and d represents the thickness (unit: m) of the dielectric layer 3. The phase of the incident electromagnetic waves and the phase of the reflected electromagnetic waves are shifted from each other by $\pi$, and a reflection attenuation is thereby obtained.

The dielectric layer 3 is formed of a resin composition having a relative permittivity higher than 10.0 at a frequency of 3.7 GHz. A dielectric layer 3 having a relative permittivity higher than 10.0 can, as described above, realize excellent absorption performance (preferably -15 dB, more preferably -20 dB) in a specific frequency band. In addition, a dielectric layer 3 having such a relative permittivity can be formed to be thin, and it is therefore possible to achieve a high level of improvement in both productivity of the dielectric layer 3 and space saving. The dielectric layer 3 has a relative permittivity at a frequency of 3.7GHz of preferably higher than 10.0 and 30.0 or less, more preferably higher than 10.0 and 20.0 or less. A dielectric layer 3 having a relative permittivity of 30.0 or less at a frequency of 3.7 GHz tends to be formed to have sufficient strength. For example, a dielectric layer 3 having an excessive amount of a dielectric compound blended therein to increase the relative permittivity thereof tends to be brittle. The thickness of the dielectric layer 3 may be set as appropriate according to the frequency band and the relative permittivity. For example, if used in millimeter wave radar and the like in the bands of 60 GHz, 76 GHz, or 90 GHz, the dielectric layer 3 preferably has a thickness of preferably 100 to 400 $\mu$m, more preferably 250 to 400 $\mu$m. When used for 5 G communication and the like in the band of 3.7 GHz, 4.5 GHz, or 28 GHz, the dielectric layer 3 has a thickness of preferably 450 to 7000 $\mu$m, more preferably 650 to 6500 $\mu$m. When used for terahertz waves, for example, the band of 300 GHz or 350 GHz recently drawing attention in next-generation communication standards and measurement and analysis techniques and in fields such as medicine, the dielectric layer 3 has a thickness of preferably 20 to 80 $\mu$m, more preferably 50 to 80 $\mu$m.

This resin composition forming the dielectric layer 3 contains at least one dielectric compound and a resin component. The relative permittivity of the dielectric layer 3 can be adjusted according to the selection of a dielectric compound in the resin composition and the content of the dielectric compound. The content of the dielectric compound is, relative to 100 parts by volume of the resin composition, preferably 10 to 300 parts by volume, more preferably 25 to 100 parts by volume. The content of the dielectric compound is, relative to 100 parts by mass of the resin composition, preferably 10 to 900 parts by mass, more preferably 25 to 100 parts by mass. With the content of the dielectric compound in the resin composition being the lower limit value or more, the dielectric layer 3 tends to have a sufficiently large relative permittivity. On the other hand, with the content being the upper limit value or less, the dielectric layer 3 tends to be efficiently manufactured by a wet coating method or extrusion molding.

Examples of the dielectric compound include metal compounds such as barium titanate, titanium oxide and zinc oxide, aluminum oxide, magnesium oxide, niobium oxide, tantalum oxide, vanadium oxide, forsterite ($Mg_2SiO_4$), barium magnesium niobate ($Ba(Mg_{1/3}Nb_{2/3})O_3$), barium neodymium titanate ($Ba_3Nd_{9.3}Ti_{18}O_{54}$), gallium nitride, and aluminum nitride. The dielectric compound preferably has the form of a powder (for example, nanoparticles). The dielectric compound preferably has a relative permittivity higher than the relative permittivity of the resin component. The dielectric compound has a relative permittivity at a frequency of 3.7 GHz or 90 GHz of preferably higher than 10 and 5000 or less, more preferably 100 to 5000, even more preferably 1000 to 5000.

Examples of the resin component include acrylic resins, methacrylic resins, silicone resins, polycarbonates, epoxy resins, glyptal resins, polyvinyl chloride, polyvinyl formal, phenolic resins, urea resins, and polychloroprene resins. The resin component has a relative permittivity at a frequency of 3.7 GHz or 90 GHz of preferably 2.5 to 9.5, more preferably 3.5 to 9.5, further preferably 5.0 to 9.5

The resin composition preferably has adhesiveness. The dielectric layer 3 can thereby be efficiently adhered to a surface 4F of the reflective layer 4. Examples of such a material include silicone adhesives, acrylic adhesives, and urethane adhesives. These materials may be used as the resin component, or an adhesive layer formed of these materials may be formed on at least one surface of the dielectric layer 3. The resin composition itself or the adhesive layer has an adhesive strength with respect to a stainless 304 steel sheet of preferably 1.0 N/25 mm or more, or may have an adhesive strength of 3.0 to 10.0 N/25 mm or 10.0 to 15.0 N/25 mm.

The complex permittivity of the dielectric layer 3 is represented by the following equation. In the equation, i is the imaginary unit, $\varepsilon'$ is the real part of complex permittivity, and $\varepsilon''$ is the imaginary part of complex permittivity.

$$\text{Complex permittivity } \varepsilon = \varepsilon' - i\varepsilon''$$

The real part of the complex permittivity is a relative permittivity (a ratio relative to the permittivity of vacuum $\varepsilon0$). The value of the imaginary part $\varepsilon''$ of the complex permittivity is derived from the value of dielectric loss tangent $\tan\delta$ (= $\varepsilon''/\varepsilon'$). The relative permittivity and the dielectric loss tangent can be obtained using a permittivity measuring device.

The real part of the complex permittivity of the dielectric layer 3 at 3.7 GHz or 90 GHz is preferably more than 10, more preferably 10.5 to 30, further preferably 12 to 20. With this value being more than 10, the dielectric layer 3 tends to be able to achieve excellent absorption performance in a specific frequency band. On the other hand, with this value being 30 or less, the dielectric layer 3 tends to be formed to have sufficient strength. The imaginary part of the complex permittivity of the dielectric layer 3 at 3.7 GHz or 90 GHz is preferably 5 or less, more preferably 0 to 3.5, further preferably 0 to 3.

(Reflective layer)

The reflective layer 4 is a layer for reflecting electromagnetic waves incident from the dielectric layer 3 and allowing them to reach the dielectric layer 3. The reflective layer 4 has a thickness of, for example, 4 to 250 $\mu$m, and may have a thickness of 4 to 12 $\mu$m or 50 to 100 $\mu$m.

The reflective layer 4 is formed of a material having conductivity, and preferably has a sheet resistance value of 100 $\Omega/\square$ or less so that it can reflect electromagnetic waves. Such a material may be an inorganic material or an organic material. Examples of the inorganic material having conductivity include nanoparticles or/and nanowires containing one or more selected from the group consisting of indium tin oxide (ITO), indium zinc oxide (IZO), aluminum zinc oxide (AZO), carbon nanotube, graphene, Ag, Al, Au, Pt, Pd, Cu, Co, Cr, In, Ag-Cu, Cu-Au, and Ni nanoparticles Examples of the organic material having conductivity include polythiophene derivatives, polyacetylene derivatives, polyaniline derivatives, and polypyrrole derivatives. A film may be formed from the inorganic material or the organic material having conductivity on a base material at a thickness such that the film has a sheet resistance of 100 $\Omega/\square$ or less. From the viewpoints of softness, film formability, stability, sheet resistance value, and low cost, a laminate film (Al-vapor-deposited PET film) including a PET film and an aluminum layer vapor-deposited on the surface thereof) is preferably used as the reflective layer.

<Method for manufacturing electromagnetic wave absorber>

The electromagnetic wave absorber 10 is manufactured, for example, through the following steps. First, a roll-shaped dielectric layer is produced, and next, a roll-shaped laminate including the dielectric layer is produced by a roll-to-roll method. This laminate is cut to a prescribed size, and the electromagnetic wave absorber 10 is thereby obtained.

The roll-shaped dielectric layer is manufactured through the steps of: (A) preparing the resin composition; and (B) forming a dielectric layer made from this resin composition by a roll-to-roll method. When the frequency band to which the electromagnetic wave absorber 10 is to be applied is high (for example, 60 GHz or higher), the electromagnetic wave absorber 10 can be manufactured by the roll-to-roll method due to the dielectric layer having a sufficiently small thickness. In contrast, when the frequency band to which the electromagnetic wave absorber 10 is to be applied is low (for example, below 28 GHz), manufacturing by the roll-to-roll method tends to be difficult due to the necessity of forming a thick dielectric layer. In this case, the dielectric layer can be formed by, for example, extrusion molding. That is, the production method may be selected as appropriate according to the frequency band to which the electromagnetic wave absorber 10 is to be applied (in other words, the thickness of the dielectric layer).

The method for manufacturing the dielectric layer and the laminate is not particularly limited, and the dielectric layer and the laminate can be manufactured using a conventionally known method such as a dry lamination method and a melt extrusion lamination method. Specifically, the dielectric layer can be produced by comma coating, die coating, extrusion film forming, or calendar film formation. For example, in the comma coating, an appropriate gap is secured between a comma roll and a coating roll, a substrate runs therebetween while a coating fluid is applied from an interspace onto the substrate film, and a film can be formed by drying the coating fluid. By using, as the substrate, PET or the like having a release treatment performed thereon, a single dielectric layer can easily be obtained in the production of the laminate. Alternatively, when the coating fluid can directly be applied onto the electromagnetic wave transmission layer or the reflective layer, a bonding step in the production of the laminate can be omitted. By adjusting the gap, the dielectric layer having any film thickness can be obtained. In the die coating, a coating fluid is applied, with an interspace called a coating gap, from a die slot onto a substrate conveyed on a back-up roll, and the dielectric layer can be produced by drying the coating fluid. By adjusting the flow rate of the fluid to be supplied, the coating gap, the substrate conveying speed, and the like, the dielectric layer having any film thickness can be obtained. Similarly as described above, the release-treated PET, the electromagnetic wave transmission layer, or the reflective layer can be used as the substrate. In extrusion film formation, the resin composition for forming the dielectric layer is supplied to a melt extruder heated at a temperature approximately from a melting point Tm of the resin composition to Tm + 100°C to melt the resin composition for forming the dielectric layer, and extruded into a sheet shape from, for example, a die head of a T-die or the like, and the extruded sheet-shaped product can be rapidly cooled and solidified by a rotating cooling drum or the like, and wound to form a film as the dielectric layer. By adjusting the degree of opening of a "lip" discharging the resin, the thickness of the dielectric layer can be controlled. When the film-forming apparatus requires attachment of a substrate for conveyance or when the laminate can be produced using heat fusion of the resin, the dielectric layer can be layered on the electromagnetic wave transmission layer or the reflective layer using the thermal fusion. In the calendar film forming, the resin is similarly melted using a mixing roll, the resin composition is fed into between two or more calendar rolls, rotated, rolled, cooled and wound, and the dielectric layer can thereby be produced. The thickness of the dielectric layer can be controlled by adjusting the clearance between the calendar rolls. When adhesion of a substrate is possible, layering is performed similarly as described above. When the dielectric layer produced by the film formation method described above has adhesiveness, the laminate can be produced by bonding the dielectric layer with the electromagnetic wave transmission layer or the reflective layer using a laminator. When the resin composition itself has no adhesiveness or has small adhesive strength, an adhesive layer can be imparted as follows: an adhesive layer is separately produced using dry lamination or the like, and lamination is performed for bonding; an adhesive layer is applied onto the resin composition itself, dried, and bonded with the electromagnetic wave transmission layer or the reflective layer used to form the laminate. Alternatively, an adhesive can be applied onto the electromagnetic wave transmission layer or the reflective layer, dried, and dry-laminated with the dielectric layer to produce the laminate.

<Second embodiment>

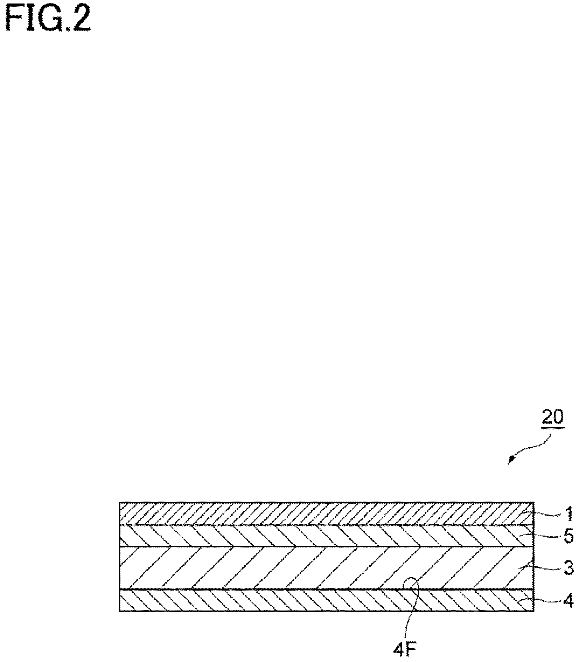

Fig. 2 is a sectional view schematically illustrating a reflective electromagnetic wave absorber according to a second embodiment. A reflective electromagnetic wave absorber 20 illustrated in this drawing has a film shape or a sheet shape, and has a laminate structure including an electromagnetic wave transmission layer 1, a resistance layer 5, a dielectric layer 3, and a reflective layer 4 in this order. The electromagnetic wave absorber 20 has the same structure as the structure of the electromagnetic wave absorber 10 according to the first embodiment except for including the resistance layer 5 between the electromagnetic wave transmission layer 1 and the dielectric layer 3. Hereinafter, the resistance layer 5 is described.

(Resistance layer)

The resistance layer 5 is a layer for allowing electromagnetic waves incident from the electromagnetic wave transmission layer 1 to reach the dielectric layer 3. That is, the resistance layer 5 is a layer for performing impedance matching according to the use environment of the electromagnetic wave absorber 20 or the characteristics of the electromagnetic wave transmission layer 1. For example, in the cases in which the electromagnetic wave absorber 20 is used in air (impedance: 377 $\Omega/\square$), the real part (relative permittivity) of the complex permittivity of the dielectric layer 3 is 2.9, and the thickness is 50 $\mu$m, a high reflection attenuation can be obtained by setting the sheet resistance value of the resistance layer 5 to the range of 270 to 500 $\Omega/\square$.

The resistance layer 5 is formed of a material having conductivity. Such a material may be an inorganic material or an organic material. Examples of the inorganic material having conductivity include nanoparticles or/and a nanowire containing one or more selected from the group consisting of indium tin oxide (ITO), indium zinc oxide (IZO), aluminum zinc oxide (AZO), carbon nanotube, graphene, Ag, Al, Au, Pt, Pd, Cu, Co, Cr, In, Ag-Cu, Cu-Au, and Ni nanoparticles. Examples of the organic material having conductivity include polythiophene derivatives, polyacetylene derivatives, polyaniline derivatives, and polypyrrole derivatives. From the viewpoints of softness, aptitude for film formation by wet coating, stability of sheet resistance in atmospheric air after film formation, and sheet resistance value, the resistance layer 5 is preferably formed of a conductive polymer containing polyethylenedioxythiophene (PEDOT). The resistance layer 5 may be formed of a mixture (PEDOT/PSS) of polyethylenedioxythiophene (PEDOT) and polystyrene sulfonicacid (PSS).

The sheet resistance value of the resistance layer 5 can be set as appropriate, for example, by selection of a material having conductivity or adjustment of the thickness of the resistance layer 5. The thickness of the resistance layer 5 is preferably in the range of 0.1 to 2.0 $\mu$m, and more preferably in the range of 0.1 to 0.4 $\mu$m. A resistance layer 5 having a film thickness of 0.1 $\mu$m or more is easier to form uniformly, and tends to be able to more sufficiently exhibit a function as the resistance layer 5. On the other hand, a resistance layer 5 having a thickness of 2.0 $\mu$m or less can retain sufficient flexibility, and tends to be able to more reliably suppress the occurrence of cracking of the thin film caused by external factors such as bending and tension after film formation. The sheet resistance value can be measured using, for example, a Loresta GP MCP-T610 (trade name, manufactured by Mitsubishi Chemical Analytech Co., Ltd.).

In the electromagnetic wave absorbers 10, 20 according to the embodiments described above, the dielectric layer 3 can be formed to be sufficiently thin because the dielectric layer 3 has a relative permittivity higher than 10.0 at a frequency of 3.7 GHz or 90 GHz. It is thereby possible to achieve high levels of both improvement in productivity of the dielectric layer 3 and space saving. In addition, the electromagnetic wave absorbers 10, 20 can achieve a return loss as large as 15 dB or more (more preferably 20 dB or more).

Heretofore, the embodiments of the present disclosure have been described in detail. The present invention, however, is not limited to the embodiments. For example, the embodiments illustrate electromagnetic wave absorbers 10, 20 having a film shape or a sheet shape. The shape of the electromagnetic wave absorber, however, is not limited to these shapes. For example, the reflective layer 4 illustrated in Figs. 1 and 2 need not have a layer shape.

[Examples]

Hereinafter, the present disclosure is described on the basis of examples and comparative examples. The present invention, however, is not limited to the following examples.

Dielectric layers according to examples and comparative examples were produced using the following materials.

(1) Resin component

· Acrylic resin: OC-3405 (manufactured by SAIDEN CHEMICAL INDUSTRY CO., LTD., relative permittivity at 3.7 GHz: 4.2)
· Silicone resin: MHM-SI500 (manufactured by Nichei Kako Co., Ltd., relative permittivity at 3.7 GHz: 3.2)
· Urethane resin: C60A10WN (manufactured by BASF Japan Ltd., relative permittivity at 3.7 GHz: 4.5)

(2) Dielectric compound

· Barium titanate powder: BT-01 (manufactured by SAKAI CHEMICAL INDUSTRY CO., LTD.)
· Titanium oxide powder: CR-60 (ISHIHARA SANGYO KAISHA, LTD.)

(Examples 1 to 3 and Comparative Examples 1 and 2)

Resin compositions having the composition shown in Table 1 were prepared. The resin compositions according to the examples and the comparative examples were evaluated for the following items.

(1) Measurement of relative permittivity

The relative permittivity of the resin compositions was measured according to the method described in JIS C 2138: 2007, using a permittivity measuring device employing the cavity resonator method in the frequency range of 1 MHz to 1 GHz under conditions of a temperature of 25°C and a relative humidity of 50%. Five samples for each level were prepared and the measurement was performed five times. Three values of relative permittivity, measured at frequencies of 1 MHz, 500 MHz, and 1 GHz, were plotted on a semilog graph, and an approximate straight line was drawn. The horizontal axis (logarithmic scale) represents frequency and the vertical axis represents relative permittivity. The relative permittivities at 3.7 GHz and 90 GHz were calculated from this approximate line. The values of relative permittivity calculated from the 5-time measurement were described in Table 1.

(2) Evaluation of adhesive strength of resin composition.

The adhesive strength of the resin compositions was evaluated according to the method described in JIS Z 0237: 2009. The resin compositions according to the examples and the comparative examples were each processed into a film having a thickness of 0.2 mm, and then cut to give a sample having a width of 25 mm. A stainless 304 steel sheet, one surface of which was mirror-finished was prepared. The sample was disposed on this surface and a 2-kg roller was then reciprocated twice for pressure bonding. After the resultant laminate was left to stand for 30 minutes, the sample peeling strength was measured by peeling the sample from the stainless 304 steel sheet at an angle of 180° using a tensile tester. The peel rate was set to 300 mm/min. Table 1 shows the results.

(3) Evaluation of adhesive strength of laminate

The acrylic resin (OC-3405) has adhesiveness. However, as the results of Examples 2 and 3 are shown in Table 1, the adhesive strength of the resin compositions was lowered along with increase in volume fraction of the dielectric compound. Therefore, samples were separately produced by layering, by a wire bar #5, the acrylic resin (OC-3405) having no dielectric compound added thereto on one surface of films produced from the resin compositions according to Examples 2 and 3. The adhesive strength of the adhesive layers made from this acrylic resin was evaluated similarly as described above. Table 1 shows the results.

(4) Evaluation of thickness of dielectric layer

Dielectric layers having thicknesses shown in Table 1 were formed by die coating. The thickness shown in Table 1 was set presuming use with 90 GHz mobile communication. Since the thickness of the dielectric layers that can be formed by one coating process is about 200 μm, coating is required only twice in Examples 1 to 3, whereas coating is required three times in Comparative Examples 1 and 2.

(5) Evaluation of number of winding meters

Table 1 shows the number of winding meters calculated presuming that the dielectric layer is wound around a core with a winding inner diameter of 3 inches and a thickness of 4 mm (outer diameter 84.2 mm) by a device with a maximum winding diameter of 700 mm. In Examples 1-3, more than 1450 m of the dielectric material can be wound per roll, whereas in Comparative Examples 1 and 2, only 1000 m or less of the dielectric material can be wound per roll.

[Table 1]

(Example 4 and Comparative Example 3)

Resin compositions having compositions shown in Table 2 were prepared. These resin compositions were evaluated similarly to Example 1 according to the items (1) to (3) and (5) described above. Since the urethane resin used as the resin component does not have adhesiveness,

|  |  | Example 1 | Example 2 | Example 3 | Comparative Example 1 | Comparative Example 2 |
|---|---|---|---|---|---|---|
| Resin component [part by volume] | Acrylic resin | 65 | 50 | 50 | 100 | - |
|  | Silicone resin | - | - | - | - | 100 |
| Dielectric compound [part by volume] | Barium titanate | 35 | 50 | - | - | - |
|  | Titanium oxide | - | - | 50 | - | - |
| Relative permittivity at 3.7 GHz | | 11.5 | 16.7 | 13.9 | 4.2 | 3.2 |
| Relative permittivity at 90 GHz | | 10.4 | 15.7 | 12.6 | 3.4 | 2.9 |
| Adhesive strength of resin composition [N/25 mm] | | 2.3 | 0.9 | 0.7 | 10.4 | 9.7 |
| Adhesive strength of laminate [N/25 mm] | | - | 9.8 | 10.0 | - | - |
| Thickness of dielectric layer [μm] | | 258 | 210 | 235 | 452 | 489 |
| Number of wound meters [m] | | 1469 | 1805 | 1613 | 838 | 775 |

samples were separately produced by layering, using a wire bar #5, the acrylic resin (OC-3405) having no dielectric compound added thereto on one surface of films produced from the resin compositions. The adhesive strength of the adhesive layers made from this acrylic resin was evaluated similarly as described above. The evaluation of item (4) was performed as follows.

(4) Evaluation of thickness of dielectric layer

Dielectric layers having the thickness shown in Table 2 were formed by calendar film forming. The thickness shown in Table 2 was set presuming use with 3.7 GHz communication. The thickness of the dielectric layers that can be formed by one calendar film forming process is about 800 μm.

[Table 2]

|  |  | Example 4 | Comparative Example 3 |
|---|---|---|---|
| Resin component [part by volume] | Urethane resin | 70 | 100 |
| Dielectric compound [part by volume] | Barium titanate | 30 | - |
| Relative permittivity at 3.7 GHz | | 12.3 | 4.5 |
| Relative permittivity at 90 GHz | | 11.1 | 3.9 |
| Adhesive strength of resin composition [N/25 mm] | | 0 | 0 |
| Adhesive strength of laminate [N/25 mm] | | 13.5 | 14.8 |
| Thickness of dielectric layer [μm] | | 6000 | 9000 |
| Number of wound meters [m] | | 63 | 42 |

(Example 5 and Comparative Example 4)

Resin compositions having compositions shown in Table 3 were prepared. These resin compositions were evaluated similarly to Example 4 according to the items (1) to (3) and (5) described above. The evaluation of the item (4) was performed as follows.

(4) Evaluation of thickness of dielectric layer

Dielectric layers having the thickness shown in Table 3 were formed by calendar film forming. The thickness shown in Table 3 was set presuming use with 28 GHz communication. However, because there was no data on the relative permittivity of the dielectric layers at 28 GHz, the thickness of the dielectric layers was set on the basis of the relative permittivity at 3.7 GHz.

[Table 3]

| | | Example 5 | Comparative Example 4 |
|---|---|---|---|
| Resin component [part by volume] | Urethane resin | 70 | 100 |
| Dielectric compound [part by volume] | Barium titanate | 30 | - |
| Relative permittivity at 3.7 GHz | | 12.3 | 4.5 |
| Relative permittivity at 90 GHz | | 11.1 | 3.9 |
| Adhesive strength of resin composition [N/25 mm] | | 0 | 0 |
| Adhesive strength of laminate [N/25 mm] | | 12.8 | 13.1 |
| Thickness of dielectric layer [$\mu$m] | | 760 | 1250 |
| Number of wound meters [m] | | 498 | 303 |

(Example 6 and Comparative Example 5)

Resin compositions having compositions shown in Table 4 were prepared. These resin compositions were evaluated similarly to Example 4 according to the items (1) to (3) and (5) described above. The evaluation of the item (4) was performed as follows.

(4) Evaluation of thickness of dielectric layer

Dielectric layers having the thickness shown in Table 4 were formed by calendar film forming. The thickness shown in Table 4 was set presuming 60 GHz communication. However, because there was no data on the relative permittivity of the dielectric layers at 60 GHz, the thickness of the dielectric layers was set on the basis of the relative permittivity at 90 GHz.

[Table 4]

| | | Example 6 | Comparative Example 5 |
|---|---|---|---|
| Resin component [part by volume] | Urethane resin | 70 | 100 |
| Dielectric compound [part by volume] | Barium titanate | 30 | - |
| Relative permittivity at 3.7 GHz | | 12.3 | 4.5 |
| Relative permittivity at 90 GHz | | 11.1 | 3.9 |
| Adhesive strength of resin composition [N/25 mm] | | 0 | 0 |
| Adhesive strength of laminate [N/25 mm] | | 11.1 | 12.5 |
| Thickness of dielectric layer [$\mu$m] | | 370 | 600 |
| Number of wound meters [m] | | 1024 | 631 |

(Example 7 and Comparative Example 6)

Resin compositions having compositions shown in Table 5 were prepared. These resin compositions were evaluated similarly to Example 4 according to the items (1) to (3) and (5) described above. The evaluation of the item (4) was performed as follows.

(4) Evaluation of thickness of dielectric layer

Dielectric layers having the thickness shown in Table 5 were formed by calendar film forming. The thickness shown in Table 5 was set presuming use with 350 GHz communication. However, because there was no data on the relative permittivity of the dielectric layers at 350 GHz, the thickness of the dielectric layers was set on the basis of the relative permittivity at 90 GHz.

[Table 5]

| | | Example 7 | Comparative Example 6 |
|---|---|---|---|
| Resin component [part by volume] | Urethane resin | 70 | 100 |
| Dielectric compound [part by volume] | Barium titanate | 30 | - |
| Relative permittivity at 3.7 GHz | | 12.3 | 4.5 |
| Relative permittivity at 90 GHz | | 11.1 | 3.9 |
| Adhesive strength of resin composition [N/25 mm] | | 0 | 0 |
| Adhesive strength of laminate [N/25 mm] | | 10.8 | 11.3 |
| Thickness of dielectric layer [$\mu$m] | | 55 | 85 |
| Number of wound meters [m] | | 6892 | 4459 |

[Reference Signs List]

| | |
|---|---|
| 1 | Electromagnetic wave transmission layer |
| 3 | Dielectric layer |
| 4 | Reflective layer |
| 4F | Surface |
| 5 | Resistance layer |
| 10, 20 | Reflective electromagnetic wave absorber |

## Claims

1. A method for manufacturing a dielectric layer included in a reflective electromagnetic wave absorber, the method comprising the steps of:

   preparing a resin composition containing at least one dielectric compound and a resin component, and having a relative permittivity higher than 10.0 at a frequency of 3.7 GHz; and
   forming a dielectric layer made from the resin composition and having a thickness of 20 to 7000 $\mu$m.

2. A method for manufacturing a dielectric layer included in a reflective electromagnetic wave absorber, the method comprising the steps of:

   preparing a resin composition containing at least one dielectric compound and a resin component, and having a relative permittivity higher than 10.0 at a frequency of 90 GHz; and
   forming a dielectric layer made from the resin composition and having a thickness of 20 to 7000 $\mu$m.

3. A resin composition used to form a dielectric layer included in a reflective electromagnetic wave absorber, the resin composition comprising:

   at least one dielectric compound; and
   a resin component,
   the resin composition having a relative permittivity higher than 10.0 at a frequency of 3.7 GHz.

4. A resin composition used to form a dielectric layer included in a reflective electromagnetic wave absorber, the resin composition comprising:

   at least one dielectric compound; and
   a resin component,
   the resin composition having a relative permittivity higher than 10.0 at a frequency of 90 GHz.

5. The resin composition according to claim 3 or 4, wherein the dielectric compound has a relative permittivity higher than a relative permittivity of the resin component.

6. The resin composition according to any one of claims 3 to 5, having adhesiveness.

7. The resin composition according to claim 6, having an adhesive strength of 1.0 N/25 mm or more with respect to a stainless 304 steel sheet.

8. The resin composition according to any one of claims 3 to 7, wherein the dielectric compound is a metal compound.

9. The resin composition according to claim8, wherein the metal compound is at least one of titanium oxide and barium titanate.

10. The resin composition according to any one of claims 3 to 9, wherein the resin component has a relative permittivity of 2.5 to 9.5 at a frequency of 3.7 GHz.

11. The resin composition according to any one of claims 3 to 9, wherein the resin component has a relative permittivity of 2.5 to 9.5 at a frequency of 90 GHz.

12. A laminate comprising:

   a dielectric layer made from the resin composition according to any one of claims 3 to 11; and
   an adhesive layer disposed on at least one surface of the dielectric layer.

FIG.1

FIG.2

## INTERNATIONAL SEARCH REPORT

| International application No. |
|---|
| **PCT/JP2021/046304** |

**A. CLASSIFICATION OF SUBJECT MATTER**

*H05K 9/00*(2006.01)i; *B32B 27/00*(2006.01)i; *H01G 4/00*(2006.01)i; *H01G 4/06*(2006.01)i; *H01G 4/20*(2006.01)i; *H01G 4/33*(2006.01)i

FI: H05K9/00 M; B32B27/00 M; H01G4/33 101; H01G4/00 A; H01G4/20 600; H01G4/06

According to International Patent Classification (IPC) or to both national classification and IPC

**B. FIELDS SEARCHED**

Minimum documentation searched (classification system followed by classification symbols)

H05K9/00; B32B27/00; H01G4/00; H01G4/06; H01G4/20; H01G4/33

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2020-161584 A (SEKISUI CHEMICAL CO LTD) 01 October 2020 (2020-10-01) paragraphs [0005], [0042]-[0052], [0064], [0065], [0081] | 1-12 |

☐ Further documents are listed in the continuation of Box C.    ☑ See patent family annex.

| | |
|---|---|
| \* Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **04 March 2022** | **15 March 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

INTERNATIONAL SEARCH REPORT
Information on patent family members

International application No.

**PCT/JP2021/046304**

| Patent document cited in search report | | | Publication date (day/month/year) | Patent family member(s) | Publication date (day/month/year) |
|---|---|---|---|---|---|
| JP | 2020-161584 | A | 01 October 2020 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005311330 A

- WO 2018230026 A